# EUROPÄISCHE PATENTSCHRIFT

(11) **EP 1 644 459 B1**
(45) Veröffentlichungstag und Bekanntmachung des Hinweises auf die Patenterteilung: **23.08.2017**
(21) Anmeldenummer: 04740735.8
(22) Anmeldetag: 07.07.2004
(51) Int. Cl.: C09K 11/06, H01L 51/30

(54) **MISCHUNGEN VON ORGANISCHEN ZUR EMISSION BEFÄHIGTEN HALBLEITERN UND MATRIXMATERIALIEN,SOWIE ELEKTRONIKBAUTEILE DIESE ENTHALTEND**
MIXTURES OF ORGANIC EMISSIVE SEMICONDUCTORS AND MATRIX MATERIALS, AND ELECTRONIC COMPONENTS COMPRISING SAID MIXTURES
MELANGES DE SEMI-CONDUCTEURS ORGANIQUES APTES A L'EMISSION ET DE MATERIAUX MATRICIELS, ET COMPOSANTS ELECTRONIQUES CONTENANT CES MELANGES

(30) Priorität: 07.07.2003 DE 10330761; 25.11.2003 DE 10355380
(43) Veröffentlichungstag der Anmeldung: 12.04.2006
(60) Teilanmeldung: 10008202.3
(73) Patentinhaber: Merck Patent GmbH, 64293 Darmstadt (DE)
(72) Erfinder: BECKER, Heinrich, 65719 Hofheim (DE); GERHARD, Anja, 97209 Veitshöchheim (DE); STÖSSEL, Philipp, 60487 Frankfurt am Main (DE); VESTWEBER, Horst, 34330 Gilserberg-Winterscheid (DE)
(86) Internationale Anmeldenummer: PCT/EP2004/007421
(87) Internationale Veröffentlichungsnummer: WO 2005/003253

(56) Entgegenhaltungen:
- FUKASE A ET AL: "HIGH-EFFICIENCY ORGANIC ELECTROLUMINESCENT DEVICES USING IRIDIUM COMPLEX EMITTER AND ARYLAMINE-CONTAINING POLYMER BUFFER LAYER" POLYMERS FOR ADVANCED TECHNOLOGIES, JOHN WILEY AND SONS, CHICHESTER, GB, Bd. 13, Nr. 8, August 2002 (2002-08), Seiten 601-604, XP001132787 ISSN: 1042-7147
- ADACHI C ET AL: "ARCHITECTURES FOR EFFICIENT ELECTROPHOSPHORESCENT ORGANIC LIGHT-EMITTING DEVICES" IEEE JOURNAL OF SELECTED TOPICS IN QUANTUM ELECTRONICS, IEEE SERVICE CENTER, US, Bd. 8, Nr. 2, März 2002 (2002-03), Seiten 372-377, XP001143529 ISSN: 1077-260X
- LEE C-L ET AL: "Highly efficient polymer phosphorescent light emitting devices" MATERIALS SCIENCE AND ENGINEERING B, ELSEVIER SEQUOIA, LAUSANNE, CH, Bd. 85, Nr. 2-3, 22. August 2001 (2001-08-22), Seiten 228-231, XP004255468 ISSN: 0921-5107
- DJUROVICH P I ET AL: "IR(III) CYCLOMETALATED COMPLEXES AS EFFICIENT PHOSPHORESCENT EMITTERS IN POLYMER BLEND AND ORGANIC LEDS" POLYMER PREPRINTS, AMERICAN CHEMICAL SOCIETY, US, Bd. 41, Nr. 1, März 2000 (2000-03), Seiten 770-771, XP001052648 ISSN: 0032-3934
- T. TSUTSUI ET.AL.: "High quantum efficiency in organic light-emitting devices with iridium-complex as a triplet emissive center" JPN. J. APPL. PHYS., Bd. 38, Nr. 12B, Dezember 1999 (1999-12), Seiten L1502-L1504, XP002308248
- C. ADACHI ET.AL.: "High-efficiency organic electrophosphorescent devices with tris(2-phenylpyridine)iridium doped into electron-transporting materials" APPLIED PHYSICS LETTERS, Bd. 77, Nr. 6, August 2000 (2000-08), Seiten 904-906, XP002308249
- NAZEERUDDIN M K ET AL: "HIGHLY PHOSPHORESCENCE IRIDIUM COMPLEXES AND THEIR APPLICATION IN ORGANIC LIGHT-EMITTING DEVICES", JOURNAL OF THE AMERICAN CHEMICAL SOCIETY, AMERICAN CHEMICAL SOCIETY, US, vol. 125, no. 29, 23 July 2003 (2003-07-23), pages 8790-8797, XP009057719, ISSN: 0002-7863, DOI: 10.1021/JA021413Y

## Beschreibung

Die vorliegende Erfindung beschreibt die Verwendung neuer Materialien und Materialmischungen in organischen elektronischen Bauteilen wie Elektrolumineszenzelementen und deren Verwendung in darauf basierenden Displays.

In einer Reihe von verschiedenartigen Anwendungen, die im weitesten Sinne der Elektronikindustrie zugerechnet werden können, ist der Einsatz organischer Halbleiter als Wirkkomponenten (= Funktionsmaterialien) seit geraumer Zeit Realität bzw. wird in naher Zukunft erwartet.

So finden schon seit etlichen Jahren lichtsensitive organische Materialien (z. B. Phthalocyanine) sowie organische Ladungstransportmaterialien (i. d. R. Lochtransporter auf Triarylaminbasis) Verwendung in Kopiergeräten.

Der Einsatz spezieller halbleitender organischer Verbindungen, die zum Teil auch zur Emission von Licht im sichtbaren Spektralbereich befähigt sind, steht gerade am Anfang der Markteinführung, zum Beispiel in organischen Elektrolumineszenzvorrichtungen. Deren Einzelbauteile, die Organischen-Lichtemittierenden-Dioden (OLEDs), besitzen ein sehr breites Anwendungsspektrum als:
1. weiße oder farbige Hinterleuchtungen für monochrome oder mehrfarbige Anzeigeelemente (wie z. B. im Taschenrechner, für Mobiltelefone und andere tragbare Anwendungen),
2. großflächige Anzeigen (wie z. B. Verkehrsschilder, Plakate und andere Anwendungen),
3. Beleuchtungselemente in allen Farben und Formen,
4. monochrome oder vollfarbige Passiv-Matrix-Displays für tragbare Anwendungen (wie z. B. Mobiltelefone, PDAs, Camcorder und andere Anwendungen),
5. vollfarbige großflächige hochauflösende Aktiv-Matrix-Displays für verschiedenste Anwendungen (wie z. B. Mobiltelefone, PDAs, Laptops, Fernseher und andere Anwendungen).

Bei diesen Anwendungen ist die Entwicklung teilweise bereits sehr weit fortgeschritten; dennoch besteht immer noch großer Bedarf an technischen Verbesserungen.

Für einfachere OLEDs enthaltende Vorrichtungen ist die Markteinführung bereits erfolgt, wie die Auto-Radios der Firma Pioneer oder eine Digitalkamera der Firma Kodak mit "Organischem Display" belegen. Allerdings gibt es immer noch erhebliche Probleme, die einer dringenden Verbesserung bedürfen:
1. So ist v. a. die operative Lebensdauer von OLEDs immer noch gering, so daß bis dato nur einfache Anwendungen kommerziell realisiert werden können.
2. Die Effizienzen von OLEDs sind zwar akzeptabel, aber auch hier sind natürlich - gerade für tragbare Anwendungen ("portable applications") - immer noch Verbesserungen erwünscht.
3. Die Alterungsprozesse gehen i. d. R. mit einem Anstieg der Spannung einher. Dieser Effekt macht spannungsgetriebene organische Elektrolumineszenzvorrichtungen, z. B. Displays oder Anzeige-Elemente, schwierig bzw. unmöglich. Eine stromgetriebene Ansteuerung ist aber gerade in diesem Fall aufwendiger und teurer.
4. Die benötigte Betriebsspannung ist gerade bei effizienten phosphoreszierenden OLEDs recht hoch und muß daher verringert werden, um die Leistungseffizienz zu verbessern. Das ist gerade für tragbare Anwendungen von großer Bedeutung.
5. Der benötigte Betriebsstrom ist ebenfalls in den letzten Jahren verringert worden, muß aber noch weiter verringert werden, um die Leistungseffizienz zu verbessern. Das ist gerade für tragbare Anwendungen besonders wichtig.
6. Durch die Vielfalt an Schichten ist der Aufbau der OLEDs komplex und technologisch sehr aufwendig. Daher wäre es wünschenswert, OLEDs mit einem einfacheren Schichtaufbau, der weniger Schichten benötigt, mit weiterhin guten Eigenschaften realisieren zu können.

Die oben unter 1. bis 7. genannten Gründe machen Verbesserungen bei der Herstellung von OLEDs notwendig.

Eine Entwicklung hierzu, die sich in den letzten Jahren abzeichnet, ist der Einsatz von metallorganischen Komplexen, die Phosphoreszenz statt Fluoreszenz zeigen [M. A. Baldo, S. Lamansky, P. E. Burrows, M. E. Thompson, S. R. Forrest, Applied Physics Letters, 1999, 75, 4-6]. Aus quantenmechanischen Gründen ist unter Verwendung metallorganischer Verbindungen eine bis zu vierfache Quanten-, Energie- und Leistungseffizienz möglich. Ob sich diese neue Entwicklung durchsetzen wird, hängt zum einen stark davon ab, ob entsprechende Device-Kompositionen gefunden werden können, die diese Vorteile (Triplett-Emission = Phosphoreszenz gegenüber Singulett-Emission = Fluoreszenz) auch in den OLEDs umsetzen können. Als wesentliche Bedingungen für die praktische Anwendung sind hier insbesondere eine hohe operative Lebensdauer, eine hohe Stabilität gegenüber Temperaturbelastung und eine niedrige Einsatz- und Betriebsspannung, um mobile Applikationen zu ermöglichen, zu nennen.

Der allgemeine Aufbau von organischen Elektrolumineszenzvorrichtungen ist beispielsweise in US 4,539,507 und US 5,151,629 sowie EP 01202358 beschrieben.
Üblicherweise besteht eine organische Elektrolumineszenzvorrichtung aus mehreren Schichten, die mittels Vakuummethoden oder unterschiedlicher Druckmethoden aufeinander aufgebracht werden. Diese Schichten sind im einzelnen:
1. Eine Trägerplatte = Substrat (üblicherweise Glas oder Kunststoffolien).
2. Eine transparente Anode (üblicherweise Indium-Zinn-Oxid, ITO).
3. Eine Lochinjektions-Schicht (**H**ole **I**njection **L**ayer = HIL): z. B. auf der Basis von Kupferphthalocyanin (CuPc) oder leitfähigen Polymeren, wie Polyanilin (PANI) oder Polythiophen-Derivaten (wie PEDOT).
4. Eine oder mehrere Lochtransport-Schichten (**H**ole **T**ransport **L**ayer = HTL): üblicherweise auf der Basis von Triarylamin-Derivaten, z. B. 4,4',4"-Tris(N-1-naphthyl-N-phenyl-amino)-triphenylamin (NaphDATA) als erste Schicht und N,N'-Di(naphth-1-yl)-N,N'-diphenyl-benzidin (NPB) als zweite Lochtransportschicht.
5. Eine oder mehrere Emissions-Schichten (**Em**ission **L**ayer = EML): diese Schicht (bzw. Schichten) kann teilweise mit den Schichten 4 bis 8 zusammenfallen, besteht aber üblicherweise aus mit Fluoreszenzfarbstoffen, z. B. N,N'-Diphenyl-chinacridon (QA), oder Phosphoreszenzfarbstoffen, z. B. Tris(phenylpyridyl)-iridium (Ir(PPy)₃) oder Tris(2-benzothiophenyl-pyridyl)-iridium (Ir(BTP)₃), dotierten Matrixmaterialien, wie 4,4'-Bis(carbazol-9-yl)-biphenyl (CBP). Die Emissionsschicht kann aber auch aus Polymeren, Mischungen von Polymeren, Mischungen von Polymeren und niedermolekularen Verbindungen oder Mischungen verschiedener niedermolekularer Verbindungen bestehen.
6. Eine Lochblockier-Schicht (Hole-Blocking-Layer = HBL): diese Schicht kann teilweise mit den Schichten 7 und 8 zusammenfallen. Sie besteht üblicherweise aus BCP (2,9-Dimethyl-4,7-diphenyl-1,10-phenanthrolin = Bathocuproin) oder Bis-(2-methyl-8-chinolinolato)-4-(phenylphenolato)-aluminium(III) (BAlq).
7. Eine Elektronentransport-Schicht (**E**lectron **T**ransport **L**ayer = ETL): meist auf Basis von Aluminium-tris-8-hydroxychinolinat (AlQ₃).
8. Eine Elektroneninjektions-Schicht (**E**lectron **I**njection **L**ayer = EIL): diese Schicht kann teilweise mit Schicht 4, 5, 6 und 7 zusammenfallen, bzw. es wird ein kleiner Teil der Kathode speziell behandelt bzw. speziell abgeschieden.
9. Eine weitere Elektroneninjektions-Schicht (**E**lectron **I**njection **L**ayer = EIL): ein dünne Schicht bestehend aus einem Material mit einer hohen Dielektrizitätskonstanten, wie z. B. LiF, Li₂O, BaF₂, MgO, NaF.
10. Eine Kathode: hier werden in der Regel Metalle, Metallkombinationen oder Metallegierungen mit niedriger Austrittsarbeit verwendet, so z. B. Ca, Ba, Cs, Mg, Al, In, Mg/Ag.

Diese ganze Vorrichtung wird entsprechend (je nach Anwendung) strukturiert, kontaktiert und schließlich auch hermetisch versiegelt, da sich i. d. R. die Lebensdauer derartiger Vorrichtungen bei Anwesenheit von Wasser und/oder Luft drastisch verkürzt. Das Gleiche gilt auch für sogenannte invertierte Strukturen, bei denen das Licht aus der Kathode ausgekoppelt wird. Bei diesen invertierten OLEDs besteht die Anode z. B aus Al/Ni/NiOx oder Al/Pt/PtOx oder anderen Metall/Metalloxid-Kombinationen, die ein HOMO größer 5 eV besitzen. Die Kathode besteht dabei aus den gleichen Materialien, die in Punkt 9 und 10 beschrieben sind, mit dem Unterschied, daß das Metall, wie z. B. Ca, Ba, Mg, Al, In usw., sehr dünn und damit transparent ist. Die Schichtdicke liegt unter 50 nm, besser unter 30 nm, noch besser unter 10 nm. Auf diese transparente Kathode kann noch ein weiteres transparentes Material aufgebracht werden, z. B. ITO (Indium-Zinn-Oxid), IZO (Indium-ZinkOxid) usw..

Organische Elektrolumineszenzvorrichtungen, bei denen die Emissionsschicht (EML) aus mehr als einer Substanz besteht, sind schon seit längerem bekannt.

Im oben genannten Aufbau kommt dem Matrixmaterial der Emissions-Schicht (EML) eine besondere Rolle zu. Das Matrixmaterial muß den Ladungstransport von Löchern und/oder Elektronen ermöglichen oder verbessern und/oder die Ladungsträgerrekombination ermöglichen oder verbessern und gegebenenfalls die bei der Rekombination entstehende Energie auf den Emitter übertragen.
Diese Aufgabe wird bei den Elektrolumineszenzvorrichtungen auf Basis phosphoreszierender Emitter bislang von Matrixmaterialien, die Carbazol-Einheiten enthalten, übernommen.

Matrixmaterialien, die Carbazol-Einheiten, wie z. B. das häufig verwendete CBP, enthalten, haben in der Praxis jedoch einige Nachteile. Diese sind unter anderem in der oftmals kurzen bis sehr kurzen Lebensdauer der mit ihnen hergestellten Devices und den häufig hohen Betriebsspannungen, die zu geringen Leistungseffizienzen führen, zu sehen. Des weiteren hat sich gezeigt, daß aus energetischen Gründen CBP für blau emittierende Elektrolumineszenzvorrichtungen ungeeignet ist, was in einer schlechten Effizienz resultiert. Außerdem ist der Aufbau der Devices sehr komplex, wenn CBP als Matrixmaterial verwendet wird, da zusätzlich eine Lochblockierschicht und eine Elektronentransportschicht verwendet werden müssen. Werden diese zusätzlichen Schichten nicht verwendet, wie z. B. von Adachi et al. (Organic Electronics 2001, 2, 37) beschrieben, so beobachtet man zwar gute Effizienzen, aber nur bei extrem geringen Helligkeiten, während die Effizienz bei höherer Helligkeit, wie sie für die Anwendung nötig ist, um mehr als eine Größenordnung geringer ist. So werden für hohe Helligkeit hohe Spannungen benötigt, so daß hier die Leistungseffizienz sehr niedrig ist, was insbesondere für Passiv-Matrix-Anwendungen ungeeignet ist.

Es wurde nun überraschend gefunden, daß die Verwendung bestimmter Matrixmaterialien in Kombination mit bestimmten Emittern zu deutlichen Verbesserungen gegenüber dem Stand der Technik, insbesondere in Bezug auf die Effizienz und in Kombination mit einer stark erhöhten Lebensdauer, führen. Zudem ist mit diesen Matrixmaterialien ein deutlich vereinfachter Schichtaufbau der OLED möglich, da weder eine separate Lochblockierschicht, noch eine separate Elektronentransport- und/oder Elektroneninjektionsschicht verwendet werden muß.

Md. K. Nazeeruddin et al. (J. Am. Chem. Soc. 2003, 125(29), 8790) beschreiben Mischungen von Ir-Komplexen mit DMSO. Mischungen von Ir-Komplexen mit aromatischen Sulfoxiden werden nicht offenbart.

Die Verwendung der nachfolgend beschriebenen Matrixmaterialien in OLEDs in Kombination mit *phosphoreszierenden* Emittern ist neu. Gegenstand der Erfindung sind deshalb Mischungen enthaltend
- mindestens ein Matrixmaterial A, und
- mindestens ein zur Emission befähigtes Emissionsmaterial B, welches eine Verbindung ist, die bei geeigneter Anregung Licht emittiert;
dadurch gekennzeichnet, dass das Matrixmaterial A ausgewählt ist aus den Verbindungen gemäß Formel (40) bis (48), 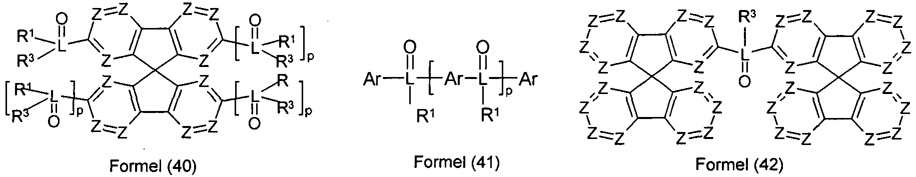 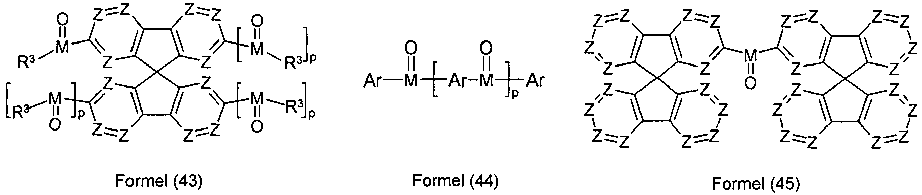 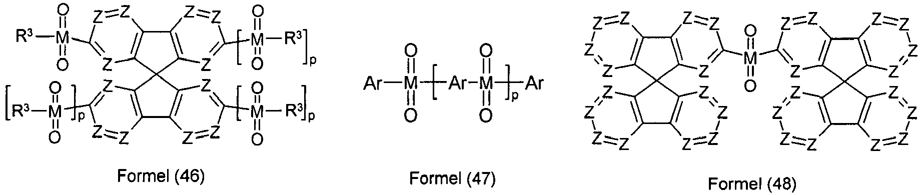 wobei für die Symbole und Indizes gilt:
- L: ist gleich oder verschieden bei jedem Auftreten P, As, Sb oder Bi;
- M: ist gleich oder verschieden bei jedem Auftreten S, Se oder Te;
- Z: ist gleich oder verschieden bei jedem Auftreten CR¹ oder N;
- R¹: ist gleich oder verschieden bei jedem Auftreten H, F, Cl, Br, I, CN, NO₂, N(R³)₂, eine geradkettige, verzweigte oder mono-, oligo- oder polycyclische Alkyl-, Alkoxy- oder Thioalkoxygruppe mit 1 bis 40 C-Atomen, wobei ein oder mehrere nicht benachbarte CH₂-Gruppen durch -R⁴C=CR⁴-, -C≡C-, Si(R⁴)₂, Ge(R⁵)₂, Sn(R⁶)₂, NR⁷, C=O, C=S, C=Se, C=NR⁸, -O-, -S-, -NR⁹- oder -CONR¹⁰- ersetzt sein können und wobei ein oder mehrere H-Atome durch F, Cl, Br, I, CN, NO₂ ersetzt sein können, oder ein aromatisches oder heteroaromatisches Ringsystem mit 1 bis 40 C-Atomen, wobei ein oder mehrere H-Atome durch F, Cl, Br, I, CN, NO₂ ersetzt sein können und das durch einen oder mehrere, nichtaromatische Reste R³ substituiert sein kann, wobei mehrere Substituenten R¹ miteinander ein weiteres mono- oder polycyclisches, aliphatisches oder aromatisches Ringsystem bilden können;
- R³: ist gleich oder verschieden bei jedem Auftreten eine geradkettige oder verzweigte oder mono-, oligo- oder polycyclische Alkyl-, Alkoxy- oder Thioalkoxygruppe mit 1 bis 40 C-Atomen, wobei ein oder mehrere nicht benachbarte CH₂-Gruppen durch -R⁴C=CR⁴-, -C≡C-, Si(R⁴)₂, Ge(R⁵)₂, Sn(R⁶)₂, NR⁷, C=O, C=S, C=Se, C=NR⁸, -O-, -S-, -NR⁹- oder -CONR¹⁰- ersetzt sein können und wobei ein oder mehrere H-Atome durch F, Cl, Br, I, CN, NO₂ ersetzt sein können, oder ein aromatisches oder heteroaromatisches Ringsystem mit 1 bis 40 C-Atomen, wobei ein oder mehrere H-Atome durch F, Cl, Br, I, CN, NO₂ ersetzt sein können und das durch einen oder mehrere, nicht-aromatische Reste R¹ substituiert sein kann, wobei mehrere Substituenten R¹ miteinander ein weiteres mono- oder polycyclisches, aliphatisches oder aromatisches Ringsystem bilden können und wobei R³ mit R¹ ein mono- oder polycyclisches, aliphatisches oder aromatisches Ringsystem bilden kann;
- R⁴, R⁵, R⁶, R⁷, R⁸, R⁹,R¹⁰: sind gleich oder verschieden bei jedem Auftreten H oder ein aliphatischer oder aromatischer Kohlenwasserstoffrest mit 1 bis 20 C-Atomen;
- Ar: ist bei jedem Auftreten gleich oder verschieden ein mono- oder bivalentes aromatisches oder heteroaromatisches Ringsystem mit 2 bis 40 C-Atomen, vorzugsweise mit 4 bis 30 C-Atomen, wobei ein oder mehrere H-Atome durch F, Cl, Br, I ersetzt sein können und das durch einen oder mehrere, nichtaromatische Reste R¹ substituiert sein kann, wobei mehrere Substituenten R¹, sowohl am selben Ring als auch an unterschiedlichen Ringen zusammen wiederum ein weiteres mono- oder polycyclisches, aliphatisches oder aromatisches Ringsystem aufspannen können;
- p: ist bei jedem Auftreten gleich oder verschieden 0 oder 1;
und dass das Emissionsmaterial B ausgewählt ist aus den Verbindungen gemäß Formel (50), 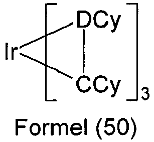 wobei für die verwendeten Symbole gilt:
- DCy: ist gleich oder verschieden bei jedem Auftreten eine cyclische Gruppe, die mindestens ein Donoratom enthält, über welches die cyclische Gruppe an das Metall gebunden ist und die wiederum einen oder mehrere Substituenten R¹¹ tragen kann; die Gruppen DCy und CCy sind über eine kovalente Bindung miteinander verbunden;
- CCy: ist gleich oder verschieden bei jedem Auftreten eine cyclische Gruppe, die ein Kohlenstoffatom enthält, über welches die cyclische Gruppe an das Metall gebunden ist und die wiederum einen oder mehrere Substituenten R¹¹ tragen kann;
- R¹¹: ist gleich oder verschieden bei jedem Auftreten H, F, CN, eine geradkettige, verzweigte oder cyclische Alkyl- oder Alkoxygruppe mit 1 bis 40 C-Atomen, wobei ein oder mehrere H-Atome durch F ersetzt sein können, oder ein aromatisches oder heteroaromatisches Ringsystem mit 4 bis 14 C-Atomen, das durch einen oder mehrere, nicht-aromatische Reste R¹¹ substituiert sein kann, wobei mehrere Substituenten R¹¹, sowohl am selben Ring als auch an den beiden unterschiedlichen Ringen zusammen wiederum ein weiteres mono- oder polycyclisches Ringsystem aufspannen können.

Bevorzugt handelt es sich bei den erfindungsgemäßen Mischungen um solche, die mindestens ein Matrixmaterial A enthalten, dessen Glastemperatur T_{g} (gemessen als Reinsubstanz) größer 70 °C ist.

Zur Klarheit sei erwähnt, das das oben und im folgenden verwendete Symbol "=" für eine Doppelbindung im Sinne der Lewis-Schreibweise steht.

Unter einem aromatischen bzw. heteroaromatischen System im Sinne dieser Erfindung soll ein System verstanden werden, das nicht notwendigerweise nur aromatische bzw. heteroaromatische Gruppen enthält, sondern in dem auch mehrere aromatische bzw. heteroaromatische Gruppen durch eine kurze nicht-aromatische Einheit (< 10 % der Atome, bevorzugt < 5 % der Atome), wie beispielsweise sp³-hybridisierter C, O, N, etc., unterbrochen sein können. So sollen also beispielsweise auch Systeme wie 9,9'-Spirobifluoren, 9,9-Diarylfluoren, Triarylamin, Diphenylether, etc. als aromatische Systeme verstanden werden.

Die Materialien der Formel (40) bis (48) weisen hohen Glasübergangstemperaturen auf. Diese liegen je nach Substitutionsmuster typischerweise über 70 °C und meist sogar oberhalb von 100 °C.

Besonders bevorzugt sind Mischungen, die eines oder mehrere der oben durch Formel (40) bis (48) beschriebenen Matrixmaterialien A enthalten, dadurch gekennzeichnet, daß
- L: ist bei jedem Auftreten P;
- M: ist bei jedem Auftreten S;
- Z: ist gleich oder verschieden bei jedem Auftreten CR¹ oder N;
- R¹, R², R³: gleich oder verschieden bei jedem Auftreten CH₃, CF₃, -HC=CH- oder ein aromatisches oder heteroaromatisches Ringsystem mit 1 bis 40 C-Atomen, wobei ein oder mehrere H-Atome durch F, Cl, Br, I ersetzt sein können und das durch einen oder mehrere, nicht-aromatische Reste R¹ substituiert sein kann, wobei mehrere Substituenten R¹ miteinander ein weiteres mono- oder polycyclisches, aliphatisches oder aromatisches Ringsystem bilden können und wobei R¹, R² und/oder R³ miteinander ein mono- oder polycyclisches, aliphatisches oder aromatisches Ringsystem bilden kann;
und wobei die verbleibenden Symbole und Indizes die oben genannte Bedeutung haben.

Besonders bevorzugt sind Mischungen, die eines oder mehrere der oben durch Formeln (40) bis (48) beschriebenen Matrixmaterialen A enthalten, dadurch gekennzeichnet, daß diese chiral sind.

Die vorliegende Erfindung wird durch die folgenden Beispiele für Matrixmaterialien A näher erläutert, ohne sie darauf einschränken zu wollen. Der Fachmann kann aus der Beschreibung und den aufgeführten Beispielen ohne erfinderisches Zutun weitere erfindungsgemäße Matrixmaterialien herstellen.

| | | |
|---|---|---|
| 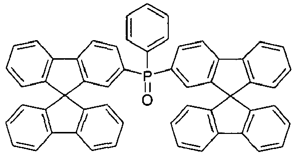 | 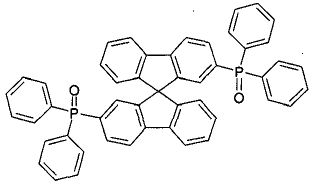 | 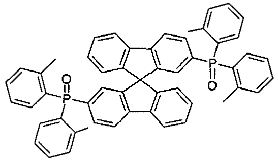 |
| Beispiel 1 | Beispiel 2 | Beispiel 3 |
| 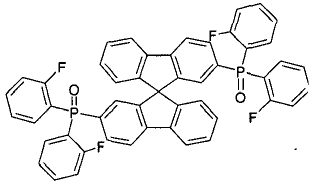 | 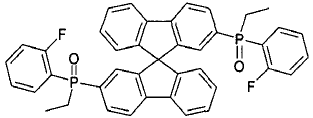 | 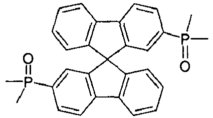 |
| Beispiel 4 | Beispiel 5 | Beispiel 6 |
| 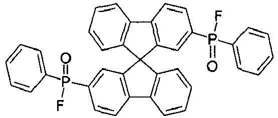 | 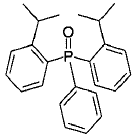 | 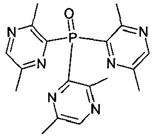 |
| Beispiel 7 | Beispiel 8 | Beispiel 9 |
| 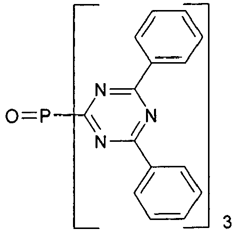 | 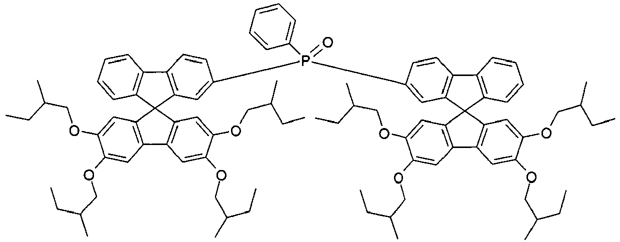 | |
| Beispiel 10 | Beispiel 14 | |
| 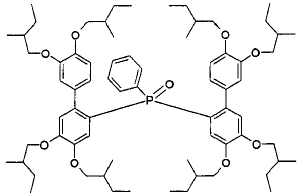 | | |
| Beispiel 15 | | |
| 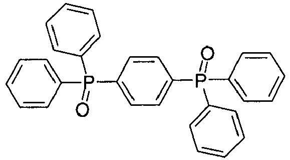 | 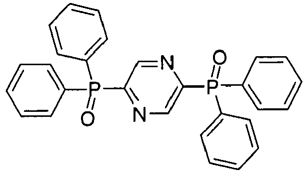 | 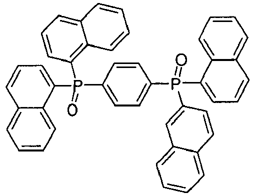 |
| Beispiel 26 | Beispiel 27 | Beispiel 28 |
| 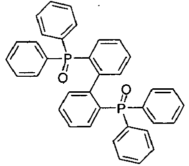 | 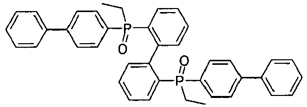 | 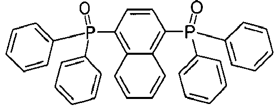 |
| Beispiel 29 | Beispiel 30 | Beispiel 31 |
| 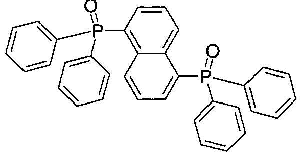 | 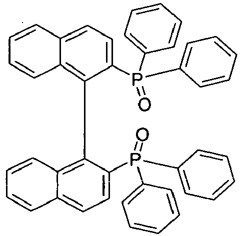 | 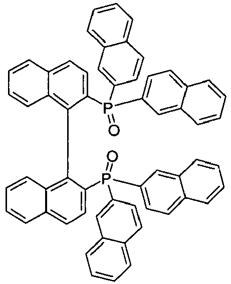 |
| Beispiel 32 | Beispiel 33 | Beispiel 34 |
| | 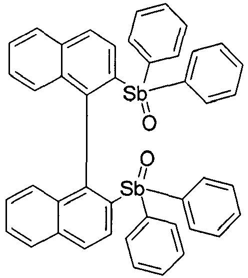 | 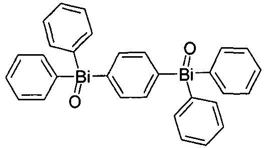 |
| | Beispiel 36 | Beispiel 37 |
| 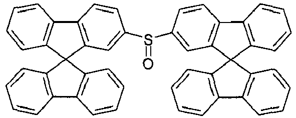 | 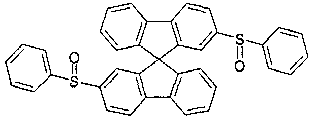 | 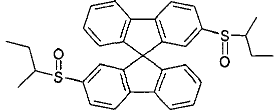 |
| Beispiel 44 | Beispiel 45 | Beispiel 46 |
| 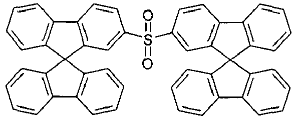 | 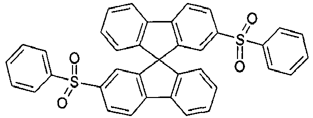 | 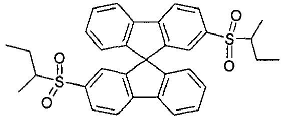 |
| Beispiel 47 | Beispiel 48 | Beispiel 49 |
| 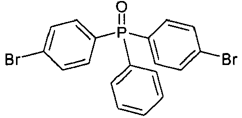 | 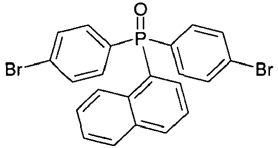 | 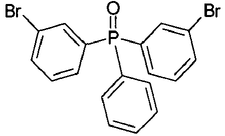 |
| Beispiel 50 | Beispiel 51 | Beispiel 52 |
| 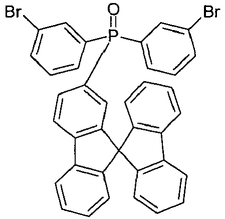 | 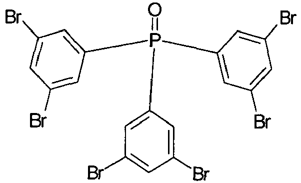 | 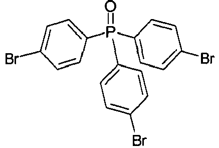 |
| Beispiel 53 | Beispiel 54 | Beispiel 55 |

Um als Funktionsmaterial Verwendung zu finden, werden die erfindungsgemäßen Matrixmaterialien A oder deren Mischungen, gegebenenfalls zusammen mit den Emittern B, nach allgemein bekannten, dem Fachmann geläufigen Methoden, wie Vakuumverdampfung, Verdampfen im Trägergasstrom oder auch aus Lösung durch Spincoaten oder mit verschiedenen Druckverfahren (z. B. Tintenstrahldrucken, Off-set-Drucken, LITI-Druck, etc.), in Form eines Films auf ein Substrat aufgebracht.

Dabei kann die Verwendung von Druckverfahren Vorteile hinsichtlich der Skalierbarkeit der Fertigung, als auch bezüglich der Einstellung von Mischungsverhältnissen in verwendeten Blend-Schichten haben.

Die oben beschriebenen Matrixmaterialien werden in Kombination mit Phosphoreszenz-Emittern gemäß Formel (50) verwendet.

Beispiele der oben beschriebenen Emitter gemäß Formel (50) können zum Beispiel den Anmeldungen WO 00/70655, WO 01/41512, WO 02/02714, WO 02/15645, EP 1191613, EP 1191612 und EP 1191614 entnommen werden.

Die erfindungsgemäße Mischung enthält zwischen 1 und 99 Gew.%, vorzugsweise zwischen 3 und 95 Gew.%, besonders bevorzugt zwischen 5 und 50 Gew.%, insbesondere zwischen 7 und 20 Gew.% Emitter B bezogen auf die Gesamtmischung aus Emitter B und Matrixmaterial A.

Weiterer Gegenstand der vorliegenden Erfindung sind elektronische Bauteile, insbesondere organische Elektrolumineszenzvorrichtungen (OLED), organische Solarzellen (O-SCs), organische Feldeffekttransistoren (O-FETs), organische optische Detektoren, organische Photorezeptoren in der Elektrophotographie oder auch organische Laserdioden (O-Laser) enthaltend die erfindungsgemäße Mischung aus Matrixmaterial A und Emissionsmaterial B.

Besonders bevorzugt sind organische Elektrolumineszenzvorrichtungen, die mindestens eine emittierende Schicht (EML) aufweist, enthaltend eine Mischung aus mindestens einem Matrixmaterial A gemäß einer der Formeln (40) bis (48) und mindestens einem zur Emission befähigten Emissionsmaterial B der Formel (50).

Die organische Elektrolumineszenzvorrichtung kann außer der Kathode, der Anode und der Emitterschicht weitere Schichten enthalten, wie z. B. Lochinjektionsschicht, Lochtransportschicht, Lochblockierschicht, Elektronentransportschicht und/oder Elektroneninjektionsschicht. Es sei aber an dieser Stelle darauf hingewiesen, daß nicht notwendigerweise jede dieser Schichten vorhanden sein muß. So hat sich beispielsweise gezeigt, daß eine OLED, die weder eine separate Lochblockierschicht, noch eine separate Elektronentransportschicht enthält, weiterhin sehr gute Ergebnisse in der Elektrolumineszenz zeigt, insbesondere eine nochmals deutlich höhere Leistungseffizienz. Dies ist besonders überraschend, da eine entsprechende OLED mit einem Carbazolhaltigen Matrixmaterial ohne Lochblockier- und Elektronentransportschicht nur sehr geringe Leistungseffizienzen zeigt, insbesondere bei hoher Helligkeit (vgl. Adachi et al., Organic Electronics 2001, 2, 37).

Ein weiterer Gegenstand der Erfindung ist also eine organische Elektrolumineszenzvorrichtung, enthaltend eine erfindungsgemäße Mischung, die ohne Verwendung einer Lochblockierschicht direkt an die Elektronentransportschicht grenzt oder die ohne Verwendung einer Lochblockierschicht und einer Elektronentransportschicht direkt an die Elektroneninjektionsschicht oder an die Kathode grenzt.

Die organischen Elektrolumineszenzvorrichtungen zeigen höhere Effizienz, deutlich längere Lebensdauer und, insbesondere ohne Verwendung einer Lochblockier- und Elektronentransportschicht, deutlich niedrigere Betriebsspannungen und höhere Leistungseffizienzen als OLEDs gemäß dem Stand der Technik, die CBP als Matrixmaterial verwenden. Durch Weglassen der Lochblockier- und Elektronentransportschichten vereinfacht sich weiterhin der Aufbau der OLED, was einen erheblichen technologischen Vorteil darstellt.

Die bevorzugten Ausführungsformen der erfindungsgemäßen Mischungen aus Matrixmaterial A und Emissionsmaterial B sind auch für die erfindungsgemäßen elektronischen Bauteile, insbesondere für die organischen Elektrolumineszenzvorrichtungen (OLED), organischen Solarzellen (O-SCs), organischen Feldeffekttransistoren (O-FETs), organische optische Detektoren, organische Photorezeptoren für die Elektrophotographie oder auch organischen Laserdioden (O-Laser) gegeben. Zur Vermeidung von unnötigen Wiederholungen wird daher auf erneute Aufzählung an dieser Stelle verzichtet.

Im vorliegenden Anmeldetext und auch in den im weiteren folgenden Beispielen wird nur auf organische Leuchtdioden und die entsprechenden Displays abgezielt. Trotz dieser Beschränkung der Beschreibung ist es für den Fachmann ohne weiteres erfinderisches Zutun möglich, entsprechende erfindungsgemäße Schichten aus den erfindungsgemäßen Mischungen herzustellen und anzuwenden, insbesondere in OLED-nahen oder verwandten Anwendungen.

Die nachfolgend beschriebenen Beispiele zeigen klar auf, daß die erfindungsgemäßen Mischungen zu einer deutlichen Verbesserung der Effizienz und der Lebendauer der mit diesen hergestellten Elektrolumineszenzvorrichtungen führen. Außerdem gelingt es bei Verwendung der Matrixmaterialien A, blau emittierende Elektrolumineszenzvorrichtungen herzustellen.

### Beispiele:

### Allgemeines Meßverfahren zur Bestimmung der Glasübungstemperatur:

Die sublimierten Proben wurden zunächst mit einer Heizrate von 10 K/min. ausgehend von 25 °C bis zum Schmelzpunkt der Substanz +50 K aufgeheizt. Anschließend wurden sie von dieser Temperatur mit einer Heizrate von 80 K/min auf 25 °C abgekühlt. Die Messung der Glasübergangstemperatur T_{g} erfolgte durch erneutes Aufheizen mit einer Heizrate von 10 K/min bis zu einer Temperatur 50 K oberhalb des Schmelzpunktes der Substanz mit einem Gerät der Fa. Netzsch DCS 204 (TASC 414/4 Controler und CC200 C Controler).

### 1. Synthese von Matrixmaterialien

Die nachfolgenden Synthesen wurden - sofern nicht anders angegeben - unter einer Schutzgasatmosphäre in getrockneten Lösemitteln durchgeführt. Die Edukte wurden von ALDRICH [Dichlorphenylphosphin] bezogen. 2-Brom-9,9'-spirobifluoren wurde nach Literaturmethoden (Pei, Jian et al., J. Org. Chem., 2002, 67(14), 4924-4936) dargestellt.

### Beispiel 1: Bis(9,9'-spiro-bifluoren-2-yl)phenylphosphinoxid (Matrixmaterial M1)

Aus einer Lösung von 98.8 g (250 mmol) 2-Brom-9,9'-spirobifluoren und 6 ml 1,2-Dichlorethan in 1000 ml THF und 7.1 g (290 mmol) Magnesium wurde in der Siedehitze das entsprechende Grignard-Reagens hergestellt. Zu dieser Grignard-Lösung wurde bei 0-5 °C eine Lösung von 16.3 ml (120 mmol) Dichlorphenylphosphin in 100 ml THF während 15 min. zugetropft. Anschließend wurde die Mischung 1 h unter Rückfluß erhitzt. Nach Abkühlen wurde die Mischung mit 10 ml Wasser versetzt und bis zur Trockene eingeengt. Der farblose Rückstand wurde in 1000 ml Dichlormethan aufgenommen, die Suspension wurde dreimal mit 300 ml Wasser gewaschen. Die organische Phase wurde abgetrennt, über Natriumsulfat getrocknet und anschließend eingeengt. Der farblose Rückstand wurde in 1000 ml Essigsäureethylester gelöst und tropfenweise unter gutem Rühren mit einem Gemisch aus 10.3 ml Wasserstoffperoxid (35 Gew.% in Wasser) und 100 ml Wasser versetzt. Nach 18 h Rühren wurde der ausgefallene farblose Feststoff abgesaugt, mit Ethanol gewaschen und getrocknet. Der Feststoff wurde dreimal aus Chlorbenzol (10 ml/g) umkristallisiert und anschließend im Hochvakuum (T = 385 °C, p = 5 x 10⁻⁵ mbar) sublimiert. Die Ausbeute bei einer Reinheit > 99.9 % nach HPLC betrug 40.1 g (53 mmol), entsprechend 42.4 % der Th.
Schmelzpunkt: Tₘ = 334 °C , Glasübergangspunkt: T_{g} = 161 °C.
³¹P-NMR (CDCl₃): □ [ppm] = 30.4 (s).
¹H-NMR (CDCl₃): □ [ppm] = 7.83 - 7.81 (m, 2 H), 7.76 - 7.75 (m, 6 H), 7.38 - 7.22 (m, 15 H), 7.15 - 7.12 (m, 2 H), 7.06 - 7.03 (m, 4 H), 6.72 - 6.71 (m, 2 H), 6.64 - 6.60 (m, 4 H).

### Beispiel 2: Bis(9,9'-spirobifluoren-2-yl)sulfoxid (Matrixmaterial M2)

Zu einer auf -78 °C gekühlten Suspension von 98.8 g (250 mmol) 2-Brom-9,9'-spirobifluoren in 1500 ml THF wurden 110 ml (275 mmol) einer n-Butyllithium-Lösung (2.5 M in Hexan) so zugetropft, daß die Temperatur nicht über -65 °C anstieg. Die Reaktionsmischung wurde 3 h bei -78 °C gerührt und dann mit einem Gemisch aus 7.2 ml (125 mmol) Thionylchlorid und 300 ml THF tropfenweise versetzt und anschließend noch weitere 3 h bei -78 °C nachgerührt. Nach Erwärmen der Reaktionsmischung auf Raumtemperatur wurde das Reaktionsgemisch mit 25 ml Wasser versetzt und im Vakuum zur Trockene eingeengt. Der Rückstand wurde in 1000 ml Dioxan und 500 ml Wasser aufgenommen, die organische Phase wurde abgetrennt, nochmals mit 500 ml Wasser gewaschen und anschließend über Magnesiumsulfat getrocknet. Anschließend wurde der nach Einengen der organischen Phase verbliebene Feststoff fünfmal aus Dioxan (1 g/ml) umkristallisiert und dann im Hochvakuum (T = 370 °C, p = 5 x 10⁻⁵ mbar) sublimiert. Die Ausbeute bei einer Reinheit > 99.9 % nach HPLC betrug 114.0 g (168 mmol), entsprechend 67.2 % der Th..
Schmelzpunkt: Tₘ = 365 °C , Glasübergangspunkt: T_{g} = 178 °C.
¹H-NMR (CDCl₃): □ [ppm] = 7.83 (m, 4H), 7.75 (m, 2H), 7.73 (m, 2H), 7.37-7.29
(br. m, 8H), 7.09-7.03 (br. m, 6H), 6.86 (m, 2H), 6.70 (m, 4H), 6.65 (m, 2H).

### Beispiel 3: 1,1'-Binaphthyl-2,2'-bis(diphenylphosphinoxid) (Matrixmaterial M3)

Die Synthese wurde durch Oxidation von racemischem 1,1'-Binaphthyl-2,2'-bis(diphenylphosphin) (erhalten von Aldrich) mit Wasserstoffperoxid in Analogie zu Beispiel 1 durchgeführt.

Die Matrixmaterialien **M1** bis **M3** sind der Übersichtlichkeit halber im Folgenden nochmals abgebildet:

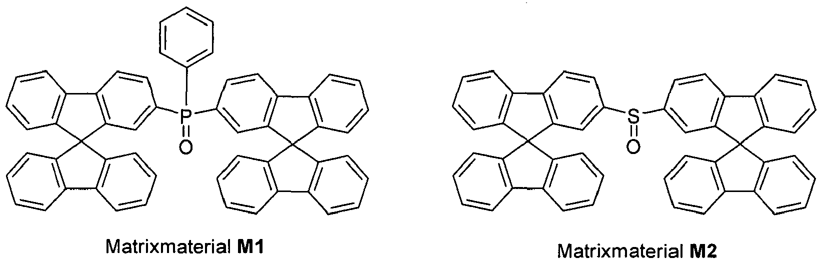

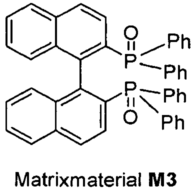

### 2. Herstellung und Charakterisierung von organischen Elektrolumineszenzvorrichtungen, die erfindungsgemäße Verbindungen enthalten

Die Herstellung von OLEDs erfolgte nach dem im Folgenden skizzierten allgemeinen Verfahren. Dieses mußte natürlich im Einzelfall auf die jeweiligen Gegebenheiten (z. B. Schichtdickenvariation, um optimale Effizienz bzw. Farbe zu erreichen) angepaßt werden. Erfindungsgemäße Elektrolumineszenzvorrichtungen können beispielsweise wie in der nicht offengelegten Anmeldung DE 10317556.3 beschrieben, dargestellt werden.

### 3. Device-Beispiele

In diesen Beispielen werden die Ergebnisse verschiedener OLEDs gegenübergestellt. Der grundlegende Aufbau, die verwendeten Materialien, der Dotierungsgrad und die Schichtdicken war für die Beispielexperimente zur besseren Vergleichbarkeit identisch. Es wurde lediglich das Wirtsmaterial in der Emitterschicht getauscht.

Das erste Beispiel beschreibt einen Vergleichsstandard gemäß dem Stand der Technik, bei dem die Emitterschicht aus dem Wirtsmaterial CBP und dem Gastmaterial Ir(PPy)₃ besteht. Des weiteren wird eine OLED mit einer Emitterschicht bestehend aus dem Wirtsmaterial Bis(9,9'-spirobifluoren-2-yl)phenylphosphinoxid (Synthese s. Beispiel 1) und dem Gastmaterial Ir(PPy)₃ (synthetisiert nach WO 02/060910) beschrieben, ebenso wie OLEDs mit weiteren erfindungsgemäßen Wirtsmaterialien. Es wurden OLEDs mit folgendem Aufbau erzeugt:

| | |
|---|---|
| PEDOT | 60 nm (aus Wasser aufgeschleudert; PEDOT bezogen von H. C. Starck; Poly[3,4-ethylendioxy-2,5-thiophen]) |
| NaphDATA | 20 nm (aufgedampft; NaphDATA bezogen von SynTec; 4,4',4"-Tris(N-1-naphthyl-N-phenyl-amino)-triphenylamin |
| S-TAD | 20 nm (aufgedampft; S-TAD hergestellt nach WO99/12888; 2,2',7,7'-Tetrakis(diphenylamino)-spirobifluoren) |
| Emitter-Schicht: | |
| CPB | 20 nm (aufgedampft; CPB bezogen von ALDRICH und weiter gereinigt, schließlich noch zweimal sublimiert; 4,4'-Bis-(N-carbazolyl)biphenyl) Vergleichsstandard) |
| ODER: | |
| Bis(9,9'-spirobifluoren-2-yl)-phenylphosphinoxid | 20 nm (aufgedampft; synthetisiert und gereinigt nach Beispiel 1) |
| ODER: | |
| Bis(9,9'-spirobifluoren-2-yl)-sulfoxid | 20 nm (aufgedampft; synthetisiert und gereinigt nach Beispiel 2) |
| ODER: | |
| 1,1'-Binaphthyl-2,2'-bis(diphenylphosphinoxid) | 20 nm (aufgedampft; synthetisiert und gereinigt nach Beispiel 3); |
| jeweils dotiert mit15 %Triplett-Emitter: | |
| Ir(PPy)₃ | (aufgedampft; synthetisiert nach WO 02/060910) |
| BCP | 10 nm (aufgedampft; BCP bezogen von ABCR, verwendet wie erhalten; 2,9-Dimethyl-4,7-diphenyl-1,10-phenanthrolin); nicht in allen Beispielen verwendet; |
| AlQ₃ | 10 nm (aufgedampft: AlQ₃ bezogen von SynTec; Tris(chinolinolato)aluminium(III)); nicht in allen Beispielen verwendet |
| Ba-Al | 3 nm Ba, darauf 150 nm Al als Kathode. |

Diese noch nicht optimierten OLEDs wurden standardmäßig charakterisiert; hierfür wurden die Elektrolumineszenzspektren, die Effizienz (gemessen in cd/A) in Abhängigkeit von der Helligkeit, berechnet aus Strom-Spannungs-Helligkeit-Kennlinien (IUL-Kennlinien), und die Lebensdauer bestimmt.

### Elektrolumineszenzspektren:

Die OLEDs, sowohl der Vergleichsstandard (OLED mit CBP), als auch die OLEDs mit Bis(9,9'-spirobifluoren-2-yl)phenylphosphinoxid, mit Bis(9,9'-spirobifluoren-2-yl)sulfoxid und mit 1,1'-Binaphthyl-2,2'-bis(diphenylphosphinoxid) als Wirtsmaterial zeigen grüne Emission, resultierend aus dem Dotanden Ir(PPy)₃.

### Effizienz als Funktion der Helligkeit:

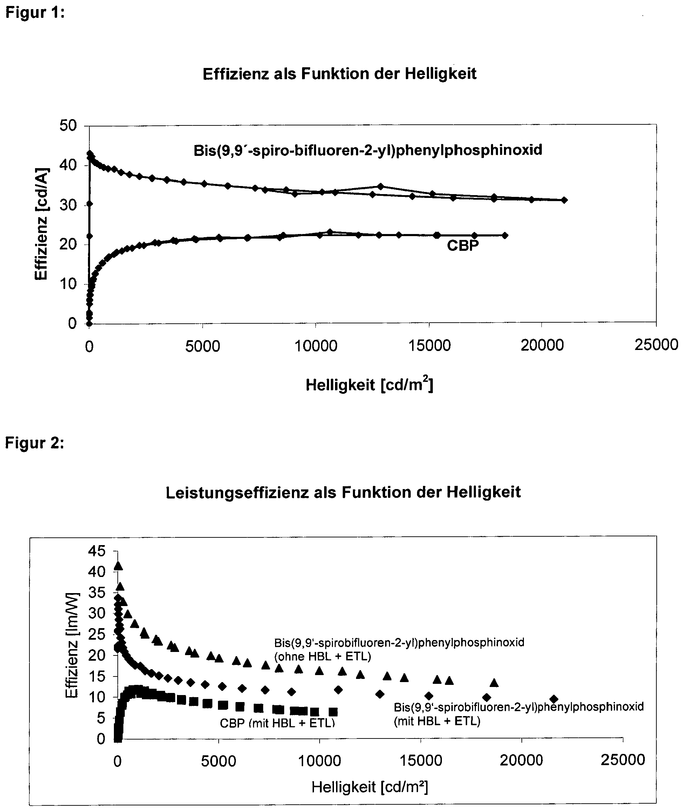

Für OLEDs hergestellt mit dem Wirtsmaterial CBP (Tabelle 1, Beispiel 1) erhält man, unter den oben beschriebenen Bedingungen, typischerweise eine Effizienz von etwa 20 bis 25 cd/A, und für die Referenzleuchtdichte von 100 cd/m² werden 4.8 V benötigt. Im Gegensatz dazu zeigen OLEDs hergestellt mit dem Wirtsmaterial Bis(9,9'-spirobifluoren-2-yl)phenylphosphinoxid eine maximale Effizienz von über 40 cd/A, wobei die benötigte Spannung für die Referenzleuchtdichte von 100 cd/m² sogar auf 4.0 V gesenkt wird (Fig.1 und Tabelle 1, Beispiel 2a).

Insbesondere wenn weder eine Lochblockierschicht (HBL), noch eine Elektronentransportschicht (ETL) verwendet werden, wenn also die dotierte Matrix (EML) an die Kathode bzw. die Elektroneninjektionsschicht grenzt, werden besonders hohe Leistungseffizienzen (gemessen in lm/W) erreicht, wie in Fig. 2 abgebildet (siehe auch Tabelle 1, Beispiel 2a). So wird beim Vergleichsstandard (unter Verwendung von BCP als Lochblockierschicht und AlQ₃ als Elektronentransportschicht) eine maximale Leistungseffizienz von 12 lm/W erreicht. Mit Bis(9,9'-spirobifluoren-2-yl)phenylphosphinoxid wird, ebenfalls unter Verwendung von BCP und AlQ₃, eine maximale Leistungseffizienz von 34 lm/W erreicht, während ohne Verwendung von BCP und AlQ₃, d. h. wenn die dotierte Matrix (EML) direkt an die Kathode angrenzt, eine maximale Leistungseffizienz von 42 lm/W erreicht wird (Tabelle 1, Beispiel 2b). Bei einer Helligkeit von 100 cd/m² ist die Leistungseffizienz immer noch 16 lm/W (mit Verwendung einer HBL und einer ETL) und 25 lm/W, wenn die dotierte Matrix (EML) direkt an die Kathode angrenzt. Weitere OLEDs mit Bis(9,9'-spirobifluoren-2-yl)sulfoxid (Beispiel 3a und 3b) und 1,1'-Binaphthyl-2,2'-bis(diphenylphosphinoxid) (Beispiel 4a und 4b) und als Wirtsmaterial zeigen sowohl mit HBL und ETL als auch ohne HBL und ETL eine verbesserte Effizienz im Vergleich zu OLEDs mit CBP (Beispiel 1) als Wirtsmaterial. Alle Beispiele sind in Tabelle 1 zusammengefaßt.

### Lebensdauervergleich:

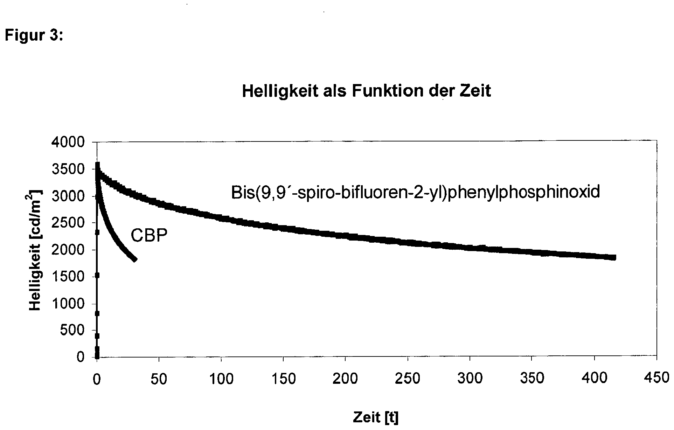

Die beiden Lebensdauerkurven mit BCP und Bis(9,9'-spirobifluoren-2-yl)phenylphosphinoxid, jeweils mit Verwendung einer HBL und einer ETL, wurden zur besseren Vergleichbarkeit in derselben Abbildung dargestellt (Fig. 3). Die Abbildung zeigt den Verlauf der Helligkeit, gemessen in cd/m², mit der Zeit. Als Lebensdauer bezeichnet man die Zeit, nach der 50 % der Anfangsleuchtdichte erreicht werden.

Man erhält bei den gezeigten Helligkeiten für CBP als Wirtsmaterial eine Lebensdauer von ca. 30 h bei einer Anfangshelligkeit von 3500 cd/m², was einer beschleunigten Messung entspricht, da die Anfangshelligkeit deutlich über der Helligkeit liegt, die man für typische Aktiv-Matrix-angesteuerte Display-Anwendungen benötigt.

Für Bis(9,9'-spirobifluoren-2-yl)phenylphosphinoxid erhält man bei derselben Anfangshelligkeit eine Lebensdauer von ca. 400 h, was einer Lebensdauer von etwa 25000 h bei 500 cd/m² und einer Steigerung der Lebensdauer um einen Faktor von mehr als 10 gegenüber OLEDs mit CPB als Matrixmaterial entspricht. Die Lebensdauer ohne Verwendung einer HBL und einer ETL, wenn also die dotierte Matrix in direktem Kontakt zur Kathode steht, ist vergleichbar. Weitere OLEDs mit Bis(9,9'-spirobifluoren-2-yl)sulfoxid (Beispiel 3a und 3b) und 1,1'-Binaphthyl-2,2'-bis(diphenylphosphinoxid) (Beispiel 4a und 4b) als Wirtsmaterial zeigen sowohl mit HBL und ETL als auch ohne HBL und ETL ebenfalls eine verbesserte Lebensdauer im Vergleich zu OLEDs mit CBP (Beispiel 1) als Wirtsmaterial. Alle Beispiele sind in Tabelle 1 zusammengefaßt.

| Experiment | EML | HBL | ETL | Max. Effizienz (cd/A) | Max. Leistungseffizienz (lm/W) | Spannung (V) bei 100cd/m² | Lebensdauer(h) bei 10 mA/cm² |
|---|---|---|---|---|---|---|---|
| Beispiel 1a) Vergleich | CBP:15% Ir(ppy)₃ (20 nm) | BCP 10(nm) | AlQ₃ (10 nm) | 22 | 12 | 4.8 | 30 |
| Beispiel 1b) Vergleich | CBP:15% Ir(ppy)₃ (40 nm) | | | 13 | 7 | 6.1 | 25 |
| Beispiel 2a) | **M1:**15% Ir(ppy)₃ (20 nm) | BCP 10(nm) | AlQ₃ (10 nm) | 42 | 34 | 4.0 | 400 |
| Beispiel 2b) | **M1:**15% Ir(ppy)₃ (40 nm) | | | 42 | 45 | 3.0 | 390 |
| Beispiel 3a) | **M2:**15% Ir(ppy)₃ (20 nm) | BCP 10(nm) | AlQ₃ (10 nm) | 28 | 25 | 4.6 | 180 |
| Beispiel 3b) | **M2**:15% Ir(ppy)₃ (40 nm) | | | 31 | 29 | 3.5 | 150 |
| Beispiel 4a) | **M3**:15% Ir(ppy)₃ (20 nm) | BCP 10(nm) | AlQ₃ (10 nm) | 25 | 13 | 5.4 | 310 |
| Beispiel 4b) | **M3**:15% Ir(ppy)₃ (40 nm) | | | 29 | 23 | 4.4 | 280 |

| | | | | | | | |
|---|---|---|---|---|---|---|---|
| Legende: **M1** = Bis(9,9'-spiro-bifluoren-2-yl)-phenylphosphinoxid **M2** = Bis(9,9'-spirobifluoren-2-yl)sulfoxid **M3 =** 1,1'-Binaphthyl-2,2'-bis(diphenylphosphinoxid) | | | | | | | |

## Patentansprüche

1. Mischungen enthaltend
- mindestens ein Matrixmaterial A, und
- mindestens ein zur Emission befähigtes Emissionsmaterial B, welches eine Verbindung ist, die bei geeigneter Anregung Licht emittiert;
**dadurch gekennzeichnet, dass** das Matrixmaterial A ausgewählt ist aus den Verbindungen gemäß Formel (40) bis (48), 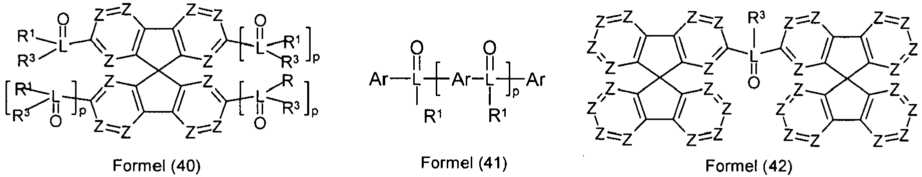 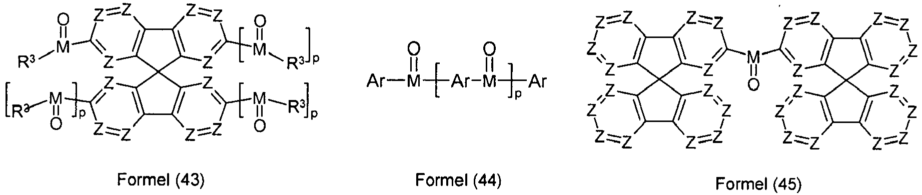 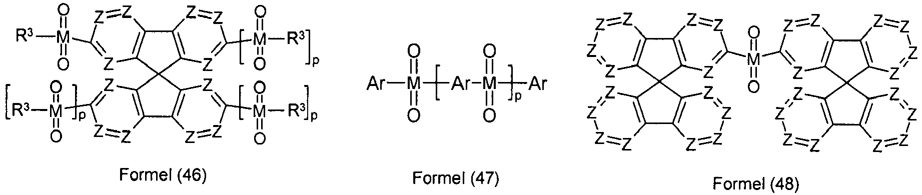 wobei für die Symbole und Indizes gilt:
L ist gleich oder verschieden bei jedem Auftreten P, As, Sb oder Bi;
M ist gleich oder verschieden bei jedem Auftreten S, Se oder Te;
Z ist gleich oder verschieden bei jedem Auftreten CR¹ oder N;
R¹ ist gleich oder verschieden bei jedem Auftreten H, F, Cl, Br, I, CN, NO₂, N(R³)₂, eine geradkettige, verzweigte oder mono-, oligo- oder polycyclische Alkyl-, Alkoxy- oder Thioalkoxygruppe mit 1 bis 40 C-Atomen, wobei ein oder mehrere nicht benachbarte CH₂-Gruppen durch -R⁴C=CR⁴-, -C≡C-, Si(R⁴)₂, Ge(R⁵)₂, Sn(R⁶)₂, NR⁷, C=O, C=S, C=Se, C=NR⁸, -O-, -S-, -NR⁹- oder -CONR¹⁰- ersetzt sein können und wobei ein oder mehrere H-Atome durch F, Cl, Br, I, CN, NO₂ ersetzt sein können, oder ein aromatisches oder heteroaromatisches Ringsystem mit 1 bis 40 C-Atomen, wobei ein oder mehrere H-Atome durch F, Cl, Br, I, CN, NO₂ ersetzt sein können und das durch einen oder mehrere, nicht-aromatische Reste R³ substituiert sein kann, wobei mehrere Substituenten R¹ miteinander ein weiteres mono- oder polycyclisches, aliphatisches oder aromatisches Ringsystem bilden können;
R³ ist gleich oder verschieden bei jedem Auftreten eine geradkettige oder verzweigte oder mono-, oligo- oder polycyclische Alkyl-, Alkoxy- oder Thioalkoxygruppe mit 1 bis 40 C-Atomen, wobei ein oder mehrere nicht benachbarte CH₂-Gruppen durch -R⁴C=CR⁴-, -C=C-, Si(R⁴)₂, Ge(R⁵)₂, Sn(R⁶)₂, NR⁷, C=O, C=S, C=Se, C=NR⁸, -O-, -S-, -NR⁹- oder -CONR¹⁰- ersetzt sein können und wobei ein oder mehrere H-Atome durch F, Cl, Br, I, CN, NO₂ ersetzt sein können, oder ein aromatisches oder heteroaromatisches Ringsystem mit 1 bis 40 C-Atomen, wobei ein oder mehrere H-Atome durch F, Cl, Br, I, CN, NO₂ ersetzt sein können und das durch einen oder mehrere, nicht-aromatische Reste R¹ substituiert sein kann, wobei mehrere Substituenten R¹ miteinander ein weiteres mono- oder polycyclisches, aliphatisches oder aromatisches Ringsystem bilden können und wobei R³ mit R¹ ein mono- oder polycyclisches, aliphatisches oder aromatisches Ringsystem bilden kann;
R⁴, R⁵, R⁶, R⁷, R⁸, R⁹,R¹⁰ sind gleich oder verschieden bei jedem Auftreten H oder ein aliphatischer oder aromatischer Kohlenwasserstoffrest mit 1 bis 20 C-Atomen;
Ar ist bei jedem Auftreten gleich oder verschieden ein mono- oder bivalentes aromatisches oder heteroaromatisches Ringsystem mit 2 bis 40 C-Atomen, vorzugsweise mit 4 bis 30 C-Atomen, wobei ein oder mehrere H-Atome durch F, Cl, Br, I ersetzt sein können und das durch einen oder mehrere, nicht-aromatische Reste R¹ substituiert sein kann, wobei mehrere Substituenten R¹, sowohl am selben Ring als auch an unterschiedlichen Ringen zusammen wiederum ein weiteres mono- oder polycyclisches, aliphatisches oder aromatisches Ringsystem aufspannen können;
p ist bei jedem Auftreten gleich oder verschieden 0 oder 1;
und dass das Emissionsmaterial B ausgewählt ist aus den Verbindungen gemäß Formel (50), 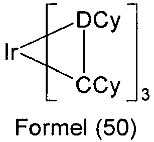 wobei für die verwendeten Symbole gilt:
DCy ist gleich oder verschieden bei jedem Auftreten eine cyclische Gruppe, die mindestens ein Donoratom enthält, über welches die cyclische Gruppe an das Metall gebunden ist und die wiederum einen oder mehrere Substituenten R¹¹ tragen kann; die Gruppen DCy und CCy sind über eine kovalente Bindung miteinander verbunden;
CCy ist gleich oder verschieden bei jedem Auftreten eine cyclische Gruppe, die ein Kohlenstoffatom enthält, über welches die cyclische Gruppe an das Metall gebunden ist und die wiederum einen oder mehrere Substituenten R¹¹ tragen kann;
R¹¹ ist gleich oder verschieden bei jedem Auftreten H, F, CN, eine geradkettige, verzweigte oder cyclische Alkyl- oder Alkoxygruppe mit 1 bis 40 C-Atomen, wobei ein oder mehrere H-Atome durch F ersetzt sein können, oder ein aromatisches oder heteroaromatisches Ringsystem mit 4 bis 14 C-Atomen, das durch einen oder mehrere, nicht-aromatische Reste R¹¹ substituiert sein kann, wobei mehrere Substituenten R¹¹, sowohl am selben Ring als auch an den beiden unterschiedlichen Ringen zusammen wiederum ein weiteres mono- oder polycyclisches Ringsystem aufspannen können.

2. Mischung gemäß Anspruch 1, **dadurch gekennzeichnet, daß** das Matrixmaterial A glasartige Schichten bilden kann.

3. Mischung gemäß Anspruch 1 oder 2, **dadurch gekennzeichnet, daß** das Matrixmaterial A eine Glastemperatur T_{g}, gemessen als Reinsubstanz, größer 70 °C aufweist.

4. Mischung gemäß einem oder mehreren der Ansprüche 1 bis 3, enthaltend als Matrixmaterial A mindestens eine Verbindung der Formel (40) bis (48), **dadurch gekennzeichnet, daß** gilt:
L ist bei jedem Auftreten P;
M ist bei jedem Auftreten S;
Z ist gleich oder verschieden bei jedem Auftreten CR¹ oder N;
R¹, R³ ist gleich oder verschieden bei jedem Auftreten CH₃, CF₃, -HC=CH- oder ein aromatisches oder heteroaromatisches Ringsystem mit 1 bis 40 C-Atomen, wobei ein oder mehrere H-Atome durch F, Cl, Br, I ersetzt sein können und das durch einen oder mehrere, nicht-aromatische Reste R¹ substituiert sein kann, wobei mehrere Substituenten R¹ miteinander ein weiteres mono- oder polycyclisches, aliphatisches oder aromatisches Ringsystem bilden können, und wobei R³ mit R¹ ein mono- oder polycyclisches, aliphatisches oder aromatisches Ringsystem bilden kann;
und wobei die verbleibenden Symbole und Indizes die in Anspruch 1 genannte Bedeutung haben.

5. Elektronisches Bauteil enthaltend mindestens eine Mischung gemäß einem oder mehreren der Ansprüche 1 bis 4.

6. Elektronisches Bauteil gemäß Anspruch 5, **dadurch gekennzeichnet, daß** es sich um eine Organische Leuchtdiode (OLED), eine Organische Integrierte Schaltung (O-IC), einen Organischen Feld-Effekt-Transistor (OFET), einen Organischen Dünnfilmtransistor (OTFT), eine Organische Solarzelle (O-SC), einen Organischen Optischen Detektor, einen Organischen Photorezeptor in der Elektrophotographie oder eine Organische Laserdiode (O-Laser) handelt.

7. Elektronisches Bauteil gemäß Anspruch 5 und/oder 6, **dadurch gekennzeichnet, daß** eine Mischung gemäß einem oder mehreren der Ansprüche 1 bis 4 ohne Verwendung einer separaten Lochblockierschicht direkt an eine Elektronentransportschicht grenzt.

8. Elektronisches Bauteil gemäß Anspruch 5 und/oder 6, **dadurch gekennzeichnet, dass** eine Mischung gemäß einem oder mehreren der Ansprüche 1 bis 4 ohne Verwendung einer separaten Lochblockierschicht und einer separaten Elektronentransportschicht direkt an eine Elektroneninjektionsschicht oder an die Kathode grenzt.

9. Elektronische Bauteil gemäß Anspruch 5 und/oder 6, **dadurch gekennzeichnet, dass** das elektronische Bauteil eine Organische Leuchtdiode (OLED) ist, die mindestens eine Lochblockierschicht und/oder mindestens eine Elektronentransportschicht und/oder mindestens eine Elektroneninjektionsschicht und/oder weitere Schichten enthält.

## Claims

1. Mixture comprising
- at least one matrix material A, and
- at least one emission-capable emission material B which is a compound which emits light on suitable excitation;
**characterised in that** the matrix material A is selected from the compounds of the formulae (40) to (48), 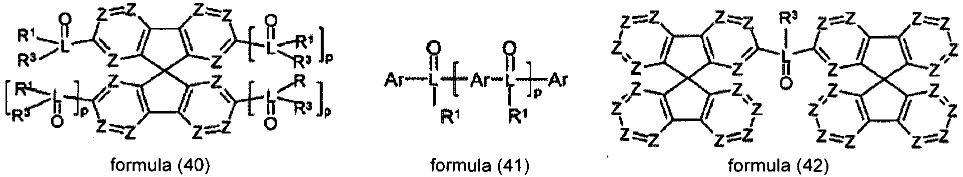 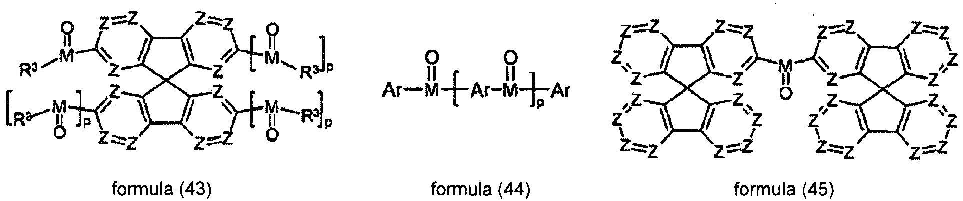 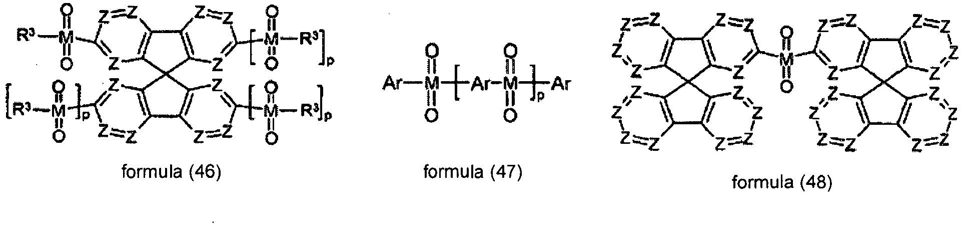 where the following applies to the symbols and indices:
L is, identically or differently on each occurrence, P, As, Sb or Bi;
M is, identically or differently on each occurrence, S, Se or Te;
Z is, identically or differently on each occurrence, CR¹ or N;
R¹ is, identically or differently on each occurrence, H, F, Cl, Br, I, CN, NO₂, N(R³)₂, a straight-chain, branched or mono-, oligo- or polycyclic alkyl, alkoxy or thioalkoxy group having 1 to 40 C atoms, where one or more non-adjacent CH₂ groups may be replaced by -R⁴C=CR⁴-, -C=C-, Si(R⁴)2, Ge(R⁵)2, Sn(R⁶)2, NR⁷, C=O, C=S, C=Se, C=NR⁸, -O-, -S-, -NR⁹- or -CONR¹⁰- and where one or more H atoms may be replaced by F, Cl, Br, I, CN, NO₂, or an aromatic or heteroaromatic ring system having 1 to 40 C atoms, where one or more H atoms may be replaced by F, Cl, Br, I, CN, NO₂ and which may be substituted by one or more, non-aromatic radicals R³, where a plurality of substituents R¹ may form a further mono- or polycyclic, aliphatic or aromatic ring system with one another;
R³ is, identically or differently on each occurrence, a straight-chain or branched or mono-, oligo- or polycyclic alkyl, alkoxy or thioalkoxy group having 1 to 40 C atoms, where one or more non-adjacent CH₂ groups may be replaced by -R⁴C=CR⁴-, -C≡C-, Si(R⁴)₂, Ge(R⁵)₂, Sn(R⁶)₂, NR⁷, C=O, C=S, C=Se, C=NR⁸, -O-, -S-, -NR⁹- or -CONR¹⁰- and where one or more H atoms may be replaced by F, Cl, Br, I, CN, NO₂, or an aromatic or heteroaromatic ring system having 1 to 40 C atoms, where one or more H atoms may be replaced by F, Cl, Br, I, CN, NO₂ and which may be substituted by one or more, non-aromatic radicals R¹, where a plurality of substituents R¹ may form a further mono- or polycyclic, aliphatic or aromatic ring system with one another and where R³ may form a mono- or polycyclic, aliphatic or aromatic ring system with R¹;
R⁴, R⁵ R⁶, R⁷, R⁸, R⁹, R¹⁰ are, identically or differently on each occurrence, H or an aliphatic or aromatic hydrocarbon radical having 1 to 20 C atoms;
Ar is on each occurrence, identically or differently, a mono- or divalent aromatic or heteroaromatic ring system having 2 to 40 C atoms, preferably having 4 to 30 C atoms, where one or more H atoms may be replaced by F, Cl, Br, I and which may be substituted by one or more, non-aromatic radicals R¹, where a plurality of substituents R¹, both on the same ring and also on different rings, together may in turn form a further mono- or polycyclic, aliphatic or aromatic ring system;
p is on each occurrence, identically or differently, 0 or 1;
and that the emission material B is selected from the compounds of the formula (50), 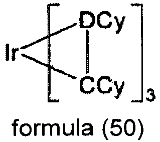 where the following applies to the symbols used:
DCy is, identically or differently on each occurrence, a cyclic group which contained at least one donor atom via which the cyclic group is bonded to the metal and which may in turn carry one or more substituents R¹¹; the groups DCy and CCy are connected to one another via a covalent bond;
CCy is, identically or differently on each occurrence, a cyclic group which contains a carbon atom via which the cyclic group is bonded to the metal and which may in turn carry one or more substituents R¹¹;
R¹¹ is, identically or differently on each occurrence, H, F, CN, a straight-chain, branched or cyclic alkyl or alkoxy group having 1 to 40 C atoms, where one or more H atoms may be replaced by F, or an aromatic or heteroaromatic ring system having 4 to 14 C atoms, which may be substituted by one or more, non-aromatic radicals R¹¹, where a plurality of substituents R¹¹, both on the same ring and also on the two different rings, together may in turn form a further mono- or polycyclic ring system.

2. Mixture according to Claim 1, **characterised in that** the matrix material A is able to form glass-like layers.

3. Mixture according to Claim 1 or 2, **characterised in that** the matrix material A has a glass temperature T_{g}, measured as the pure substance, of greater than 70°C.

4. Mixture according to one or more of Claims 1 to 3, comprising, as matrix material A, at least one compound of the formulae (40) to (48), **characterised in that** the following applies:
L is on each occurrence P;
M is on each occurrence S;
Z is, identically or differently on each occurrence, CR¹ or N;
R¹, R³ are, identically or differently on each occurrence, CH₃, CF₃, -HC=CH- or an aromatic or heteroaromatic ring system having 1 to 40 C atoms, where one or more H atoms may be replaced by F, Cl, Br, I and which may be substituted by one or more, non-aromatic radicals R¹, where a plurality of substituents R¹ may form a further mono- or polycyclic, aliphatic or aromatic ring system with one another, and where R³ may form a mono- or polycyclic, aliphatic or aromatic ring system with R¹;
and where the remaining symbols and indices have the meanings given in Claim 1.

5. Electronic component containing at least one mixture according to one or more of Claims 1 to 4.

6. Electronic component according to Claim 5, **characterised in that** it is an organic light-emitting diode (OLED), an organic integrated circuit (O-IC), an organic field-effect transistor (OFET), an organic thin-film transistor (OTFT), an organic solar cell (O-SC), an organic optical detector, an organic photoreceptor in electrophotography or an organic laser diode (O-laser).

7. Electronic component according to Claim 5 and/or 6, **characterised in that** a mixture according to one or more of Claims 1 to 4 is directly adjacent to an electron-transport layer without the use of a separate hole-blocking layer.

8. Electronic component according to Claim 5 and/or 6, **characterised in that** a mixture according to one or more of Claims 1 to 4 is directly adjacent to an electron-injection layer or to the cathode without the use of a separate hole-blocking layer and a separate electron-transport layer.

9. Electronic component according to Claim 5 or 6, **characterised in that** the electronic component is an organic light-emitting diode (OLED) which comprises at least one hole-blocking layer and/or at least one electron-transport layer and/or at least one electron-injection layer and/or further layers.

## Revendications

1. Mélange comprenant:
- au moins un matériau de matrice A, et
- au moins un matériau d'émission susceptible de réaliser une émission B qui est un composé qui émet de la lumière suite à une excitation appropriée ;
**caractérisé en ce que** le matériau de matrice A est sélectionné parmi les composés des formules (40) à (48) : 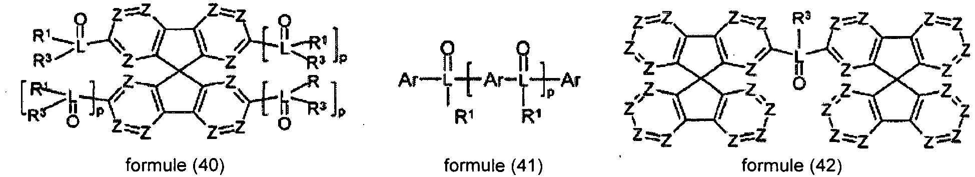 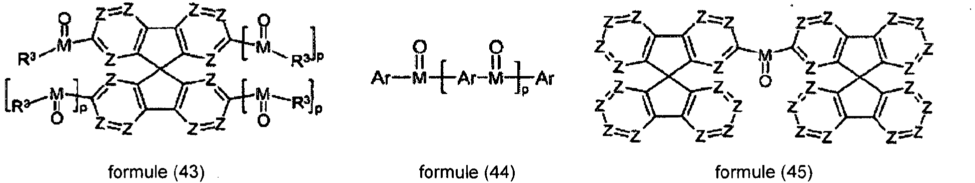 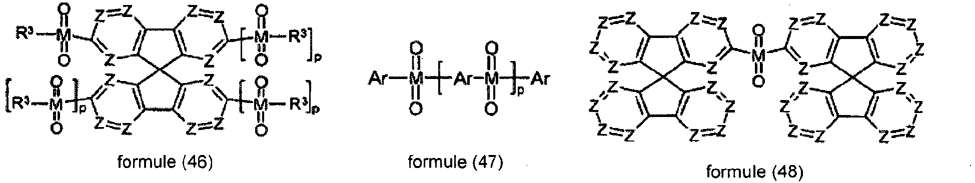 dans lesquelles ce qui suit s'applique aux symboles et indices :
L est, de manière identique ou différente pour chaque occurrence, P, As, Sb ou Bi;
M est, de manière identique ou différente pour chaque occurrence, S, Se ou Te;
Z est, de manière identique ou différente pour chaque occurrence, CR¹ ou N ;
R¹ est, de manière identique ou différente pour chaque occurrence, H, F, CI, Br, I, CN, NO₂, N(R³)₂, un groupe alkyle, alcoxy ou thioalcoxy en chaîne droite, ramifié ou monocyclique qui comporte 1 à 40 atome(s) de C, où un ou plusieurs groupe(s) CH₂ non adjacents peut/peuvent être remplacé(s) par -R⁴C=CR⁴-, -C≡C-, Si(R⁴)₂, Ge(R⁵)₂, Sn(R⁶)₂, NR⁷, C=O, C=S, C=Se, C=NR⁸, -O-, -S-, -NR⁹- ou -CONR¹⁰- et où un ou plusieurs atome(s) de H peut/ peuvent être remplacé(s) par F, CI, Br, I, CN, NO₂, ou un système de cycle aromatique ou hétéroaromatique qui comporte 1 à 40 atome(s) de C, où un ou plusieurs atome(s) de H peut/peuvent être remplacé(s) par F, CI, Br, I, CN, NO₂ et lequel peut être substitué par un radical ou plusieurs radicaux non aromatique(s) R³, où les substituants d'une pluralité de substituants R¹ peuvent former un autre système de cycle aliphatique ou aromatique monocyclique ou polycyclique les uns avec les autres ;
R³ est, de manière identique ou différente pour chaque occurrence, un groupe alkyle, alcoxy ou thioalcoxy en chaîne droite ou ramifié ou monocyclique, oligocyclique ou polycyclique qui comporte 1 à 40 atome(s) de C, où un ou plusieurs groupe(s) CH₂ non adjacents peut/peuvent être remplacé(s) par -R⁴C=CR⁴-, -C≡C-, Si(R⁴)₂, Ge(R⁵)₂, Sn(R⁶)₂, NR⁷, C=O, C=S, C=Se, C=NR⁸, -O-, -S-, -NR⁹- ou -CONR¹⁰- et où un ou plusieurs atome(s) de H peut/ peuvent être remplacé(s) par F, CI, Br, I, CN, NO₂, ou un système de cycle aromatique ou hétéroaromatique qui comporte 1 à 40 atome(s) de C, où un ou plusieurs atome(s) de H peut/peuvent être remplacé(s) par F, CI, Br, I, CN, NO₂ et lequel peut être substitué par un radical ou plusieurs radicaux non aromatique(s) R¹, où les substituants d'une pluralité de substituants R¹ peuvent former un autre système de cycle aliphatique ou aromatique monocyclique ou polycyclique les uns avec les autres et où R³ peut former un système de cycle aliphatique ou aromatique monocyclique ou polycyclique avec R¹;
R⁴, R⁵, R⁶, R⁷, R⁸, R⁹, R¹⁰ sont, de manière identique ou différente pour chaque occurrence, H ou un radical hydrocarbone aliphatique ou aromatique qui comporte 1 à 20 atome(s) de C,
Ar est pour chaque occurrence, de manière identique ou différente, un système de cycle aromatique ou hétéroaromatique monovalent ou divalent qui comporte 2 à 40 atomes de C, de façon préférable qui comporte 4 à 30 atomes de C, où un ou plusieurs atome(s) de H peut/peuvent être remplacé(s) par F, CI, Br, I et lequel peut être substitué par un radical ou plusieurs radicaux non aromatique(s) R¹, où les substituants d'une pluralité de substituants R¹, à la fois sur le même cycle et également sur des cycles différents, peuvent en association à leur tour former un autre système de cycle aliphatique ou aromatique monocyclique ou polycyclique ;
p est pour chaque occurrence, de manière identique ou différente, 0 ou 1 ;
et **en ce que** le matériau d'émission B est sélectionné parmi les composés de la formule (50) : 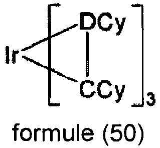 dans laquelle ce qui suit s'applique aux symboles utilisés :
DCy est, de manière identique ou différente pour chaque occurrence, un groupe cyclique qui contient au moins un atome de donneur via lequel le groupe cyclique est lié au métal et lequel peut à son tour porter un ou plusieurs substituant(s) R¹¹ ; les groupes DCy et CCy sont connectés l'un à l'autre via une liaison covalente ;
CCy est, de manière identique ou différente pour chaque occurrence, un groupe cyclique qui contient un atome de carbone via lequel le groupe cyclique est lié au métal et lequel peut à son tour porter un ou plusieurs substituant(s) R¹¹;
R¹¹ est, de manière identique ou différente pour chaque occurrence, H, F, CN, un groupe alkyle ou alcoxy en chaîne droite, ramifié ou cyclique qui comporte 1 à 40 atome(s) de C, où un ou plusieurs atome(s) de H peut/peuvent être remplacé(s) par F, ou un système de cycle aromatique ou hétéroaromatique qui comporte 4 à 14 atomes de C, lequel peut être substitué par un radical ou plusieurs radicaux non aromatique(s) R¹¹, où les substituants d'une pluralité de substituants R¹¹, à la fois sur le même cycle et également sur les deux cycles différents, peuvent en association à leur tour former un autre système de cycle monocyclique ou polycyclique.

2. Mélange selon la revendication 1, **caractérisé en ce que** le matériau de matrice A dispose de la capacité de former des couches similaires à du verre.

3. Mélange selon la revendication 1 ou 2, **caractérisé en ce que** le matériau de matrice A présente une température de transition vitreuse T_{g}, mesurée en tant que substance pure, supérieure à 70°C.

4. Mélange selon une ou plusieurs des revendications 1 à 3, comprenant, en tant que matériau de matrice A, au moins un composé des formules (40) à (48), **caractérisé en ce que** ce qui suit s'applique :
L est pour chaque occurrence P ;
M est pour chaque occurrence S,
Z est, de manière identique ou différente pour chaque occurrence, CR¹ ou N ;
R¹, R³ sont, de manière identique ou différente pour chaque occurrence, CH₃, CF₃, -HC=CH- ou un système de cycle aromatique ou hétéroaromatique qui comporte 1 à 40 atome(s) de C, où un ou plusieurs atome(s) de H peut/peuvent être remplacé(s) par F, Cl, Br, I et lequel peut être substitué par un radical ou plusieurs radicaux non aromatique(s) R¹, où les substituants d'une pluralité de substituants R¹ peuvent former un autre système de cycle aliphatique ou aromatique monocyclique ou polycyclique les uns avec les autres, et où R³ peut former un système de cycle aliphatique ou aromatique monocyclique ou polycyclique avec R¹ ;
et où les symboles et indices restants présentent les significations données selon la revendication 1.

5. Composant électronique qui contient au moins un mélange selon une ou plusieurs des revendications 1 à 4.

6. Composant électronique selon la revendication 5, **caractérisé en ce qu'**il s'agit d'une diode émettrice de lumière organique (OLED), d'un circuit intégré organique (O-IC), d'un transistor à effet de champ organique (OFET), d'un transistor à film mince organique (OTFT), d'une cellule solaire organique (O-SC), d'un détecteur optique organique, d'un photorécepteur organique en électrophotographie ou d'une diode laser organique (O-laser).

7. Composant électronique selon la revendication 5 et/ou 6, **caractérisé en ce qu'**un mélange selon une ou plusieurs des revendications 1 à 4 est directement adjacent à une couche de transport d'électrons sans l'utilisation d'une couche de blocage de trous séparée.

8. Composant électronique selon la revendication 5 et/ou 6, **caractérisé en ce qu'**un mélange selon une ou plusieurs des revendications 1 à 4 est directement adjacent à une couche d'injection d'électrons ou à la cathode sans l'utilisation d'une couche de blocage de trous séparée et sans l'utilisation d'une couche de transport d'électrons séparée.

9. Composant électronique selon la revendication 5 ou 6, **caractérisé en ce que** le composant électronique est une diode émettrice de lumière organique (OLED) qui comprend au moins une couche de blocage de trous et/ou au moins une couche de transport d'électrons et/ou au moins une couche d'injection d'électrons et/ou d'autres couches.
